# EUROPÄISCHE PATENTSCHRIFT

(11) **EP 1 479 056 B1**
(45) Veröffentlichungstag und Bekanntmachung des Hinweises auf die Patenterteilung: **05.09.2007**
(21) Anmeldenummer: 03742525.3
(22) Anmeldetag: 15.02.2003
(51) Int. Cl.: G08C 17/02, C30B 25/16, C23C 14/54

(54) **VORRICHTUNG ZUM ABSCHEIDEN DÜNNER SCHICHTEN MIT DRAHTLOSER PROZESSPARAMETER-AUFNAHME**
DEVICE FOR DEPOSITING THIN LAYERS WITH A WIRELESS DETECTION OF PROCESS PARAMETERS
DISPOSITIF POUR DEPOSER DES COUCHES MINCES AVEC RELEVEMENT SANS FIL D'UNE MESURE DE PARAMETRE DE PROCESSUS

(30) Priorität: 22.02.2002 DE 10207901
(43) Veröffentlichungstag der Anmeldung: 24.11.2004
(73) Patentinhaber: Aixtron AG, 52072 Aachen (DE)
(72) Erfinder: BAUMANN, Peter, 52072 Aachen (DE); STRAUCH, Gerd, 52072 Aachen (DE); SCHUMACHER, Marcus, 50171 Kerpen (DE); FRANKEN, Walter, 52249 Eschweiler (DE)
(74) Vertreter: Grundmann, Dirk
(86) Internationale Anmeldenummer: PCT/EP2003/001550
(87) Internationale Veröffentlichungsnummer: WO 2003/071504

(56) Entgegenhaltungen:
- WO-A-99/66473
- DE-A- 3 405 559
- DE-A- 10 032 868
- DE-A- 19 933 978
- US-A- 5 745 240
- US-B1- 6 328 802

## Beschreibung

Die Erfindung betrifft eine Vorrichtung zum Abscheiden dünner, insbesondere kristalliner Schichten auf mindestens einem insbesondere kristallinen Substrat, mit einem in einem Reaktorgehäuse drehbar gelagerten Substrathalter und mit mindestens einem Sensor zum Messen eines Prozessparameters und einem Weiterleitungsmittel zum Weiterleiten des gemessenen Wertes an eine Auswerteeinrichtung.

Vorrichtungen zum Abscheiden dünner Schichten sind bereits aus der DE 199 40 033 A1, DE 199 19 902 A1, WO 01/65592, WO 01/55478 bzw. WO 01/146498 bekannt. Diese Schriften beschreiben insbesondere solche Vorrichtungen, bei denen der Substrathalter drehangetrieben wird.

Im Stand der Technik sind CVD-Anlagen bekannt, bei denen zur Steuerung der Prozessbedingungen die Prozessparameter wie Temperatur des Substrates oder Gasdruck innerhalb der Prozesskammer gemessen werden. Diese Messwerte werden mittels Weiterleitungsmittel, in Form von elektrischen Leitungen oder optischen Leitungen an eine Auswerteeinrichtung, beispielsweise einer elektronischen Steuereinrichtung weitergeleitet. Die Erfassung und die Kontrolle von Prozessbedingungen erfolgt somit nur indirekt und nicht ortsnah. Die Messwerte können von den tatsächlich vor Ort existierenden Werten abweichen. Außerdem werden die Messwerte ortsfest zum Bezugssystem Prozesskammer ermittelt und nicht ortsfest zum Bezugssystem drehender Substrathalter. Die Qualität der Schichten, die auf Substraten, die auf drehangetriebenen Substrathalter liegen, abgeschieden werden, hängt empfindlich von einer Vielzahl von Prozessbedingungen ab. Diese müssen genau und reproduzierbar bestimmt und kontrolliert werden. Die örtliche Verteilung der Prozessbedingungen innerhalb des CVD-Reaktors und insbesondere an dem rotierenden Substrathalter ist hierfür besonders wichtig.

Der Anspruch 1 sieht vor, dass das Weiterleitungsmittel einen Sender und einem Empfänger zur drahtlosen Übermittlung des gemessenen Wertes aufweist, wobei der Sender einer Antriebswelle für den Substrathalter zugeordnet und der Empfänger außerhalb des Reaktorgehäuses angeordnet und eine die Antriebswelle bzw. einen die Antriebswelle aufnehmenden Wellenkanal umgebende Ringantenne ist. Der Sensor liegt innerhalb des Reaktorgehäuses und der Empfänger außerhalb des Reaktorgehäuses. Dem Sensor ist eine Antriebswelle für den Substrathalter zugeordnet. Der Sensor dreht sich mit dem Substrathalter mit. Der Empfänger ist ortsfest angeordnet. Der Empfänger ist als Ringantenne ausgebildet und umgibt die Antriebswelle für den Substrathalter oder den Wellenkanal, in welchem die Antriebswelle verläuft. Als Sensor kommt insbesondere ein Thermoelement in Betracht, welches sich im Substrathalter befindet. Die Zuleitungen zum Thermoelement können durch die Antriebswelle geführt sein bis zum Sender. Dieser Sender kann gleichzeitig eine Auswerteschaltung für das vom Thermoelement abgegebene elektrische Signal aufweisen. Dieses Signal wird in geeigneter Form aufbereitet und mittelst des Senders an den Empfänger gesandt. Es ist insbesondere von Vorteil, wenn der Sender die Messwerte einer Vielzahl von Sensoren an den Empfänger weiterleitet. Die Vielzahl der Sensoren kann eine Vielzahl von Thermoelementen umfassen. Es können aber auch mehrere Drucksensoren vorgesehen sein. Auch hier ist es von Vorteil, wenn die Druckaufnehmer ortsnah am Sender angeordnet sind. Druckaufnehmer bzw. Sensor befinden sich in einem mit Inertgas gespülten Bereich des Inneren des Reaktorgehäuses. Die Druckaufnehmer können mittelst Kapillaren mit den Orten verbunden sein, an welchen die Drucke aufgenommen werden sollen. Diese Kapillare können beispielsweise von dünnen Edelstahlrohren ausgebildet sein. Die Sensoren, also die Thermoelemente bzw. die Enden der Kapillaren sind an verschiedenen Stellen des Substrathalters anordbar. So können die Sensoren in verschiedenen Radialpositionen im Substrathalter angeordnet sein. Sie können aber auch an verschiedenen Umfangspositionen dort angeordnet sein. Die Thermoelemente können nahe der Oberfläche angeordnet sein und unmittelbar unterhalb des Substrates sitzen, um die Temperatur der Substratrückseite zu messen. Die Thermoelemente können aber auch im Volumen des aus Graphit bestehenden Substrathalters angeordnet sein, um dort die Temperatur zu messen.

Erfindungsgemäß werden die Messwerte telemetrisch von einem Messwertaufnehmer an eine Auswerteeinheit übermittelt. Es ist insbesondere eine Vielzahl von gleichen oder unterschiedlichen Sensoren vorgesehen, deren Messwerte drahtlos an eine Datenaufbereitungsstelle übermittelt werden. Durch die direkte Temperaturmessung entfallen die Nachteile einer optischen Temperaturmessung, die von der Oberflächenemissivität abhängig ist. Dadurch, dass an mehreren Stellen Kapillaren im Substrathalter untergebracht sind, lässt sich die Druckverteilung oberhalb des Substrathalters in der Prozesskammer ermitteln. Es lässt sich unmittelbar der Druck am Rand des Substrates ermitteln und zwar an verschiedenen Umfangspositionen des Substrates. Hierdurch ist auch die Strömungsverteilung innerhalb der Prozesskammer bestimmbar. Der Substrathalter besitzt eine Kreisscheibenform. Die Gaszufuhr erfolgt im Zentrum oberhalb des Substrathalters, so dass sich das zugeführte Gas radial nach außen verlagert. Diese Gasströmung wird durch die Druckverhältnisse beeinflusst.

Ausführungsbeispiele der Erfindung werden nachfolgend anhand beigefügter Zeichnungen erläutert. Es zeigen:
- Fig. 1: in grob schematischer Darstellung den unteren Teil eines Reaktionsgehäuses mit einem drehangetriebenen Substrathalter und darauf aufliegendem Substrat;
- Fig. 2: eine Draufsicht auf ein zweites Ausführungsbeispiel der Erfindung;
- Fig. 3: einen Schnitt gemäß der Linie III-III in Fig. 2;
- Fig. 4: ein drittes Ausführungsbeispiel der Erfindung in der Draufsicht gemäß Fig. 2 und
- Fig. 5: einen Schnitt gemäß der Linie V-V in Fig. 4.

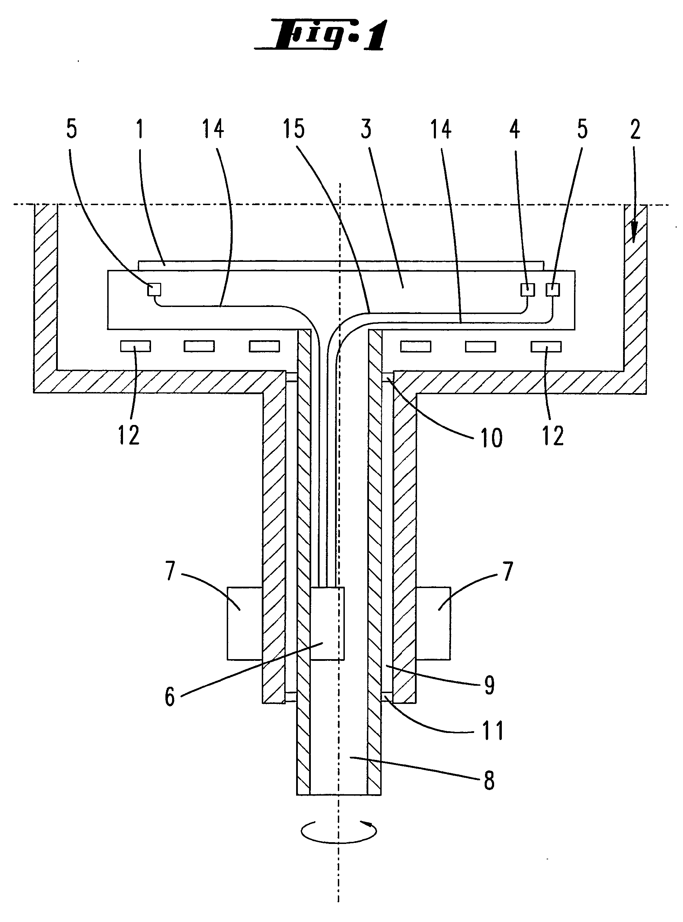

Das Reaktorgehäuse 2 ist in der Figur 1 nur grob schematisch und teilweise dargestellt. Es handelt sich um einen MOCVD-Reaktor mit einer zentralen Gaszuführung, die in den Zeichnungen nicht dargestellt ist, und die sich unmittelbar oberhalb des Substrates 1 befindet. Reaktorgehäuse der in Rede stehenden Art werden insbesondere von der DE 199 40 033 A1, der DE 19919 902 A1, der WO 01/65592, der WO 01/55478 und der WO 01/146498 beschrieben.

Das Substrat 1 liegt auf einem kreisscheibenförmigen Substrathalter 3 auf, welcher aus Graphit gefertigt ist. Unterhalb des Substrathalters 3 befindet sich eine Hochfrequenzheizung 12, mit welcher der Substrathalter 3 auf die Prozesstemperatur gebracht werden kann. Der Substrathalter 3 wird während des Beschichtungsprozesses drehangetrieben. Hierzu dient eine Antriebswelle 8, die hohl ausgebildet ist und die in einem Wellenkanal 9 verläuft. Die Antriebswelle 8 ist mittelst Drehlagern 10 und 11 in dem Wellenkanal 9 drehgelagert.

Mit den Bezugsziffern 4 und 5 sind Sensoren dargestellt, die sich innerhalb des Substrathalters 3 befinden und sich demzufolge mitdrehen. Zu den Sensoren 4, 5 führen Leitungen 14,15. Diese Leitungen 14,15 verbinden die Sensoren 4, 5 mit einem Sender 6, der auch eine Messwertaufbereitungsschaltung umfasst.

Die von den Sensoren 4, 5 gemessenen Werte werden mittelst der Leitungen 14, 15 an die Aufbereitungsschaltung weitergeleitet. Der Sender 6 übermittelt die Messwerte an eine die Antriebswelle 8 bzw. den Wellenkanal 9 umgebende Ringantenne 7. Der von der Ringantenne 7 ausgebildete Empfänger überträgt diese Messwerte an eine nicht dargestellte Auswerteeinrichtung.

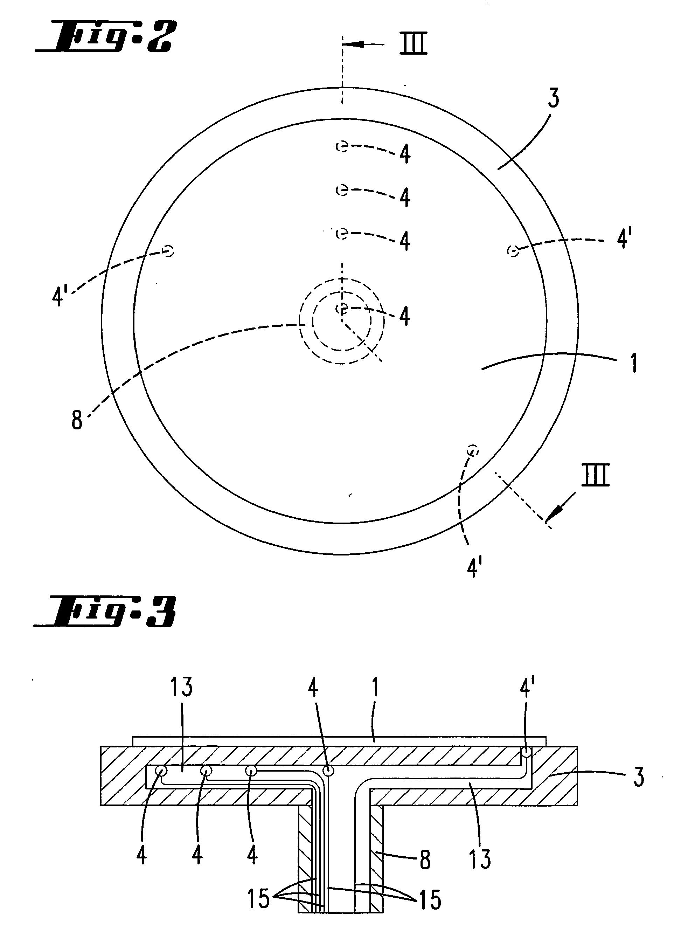

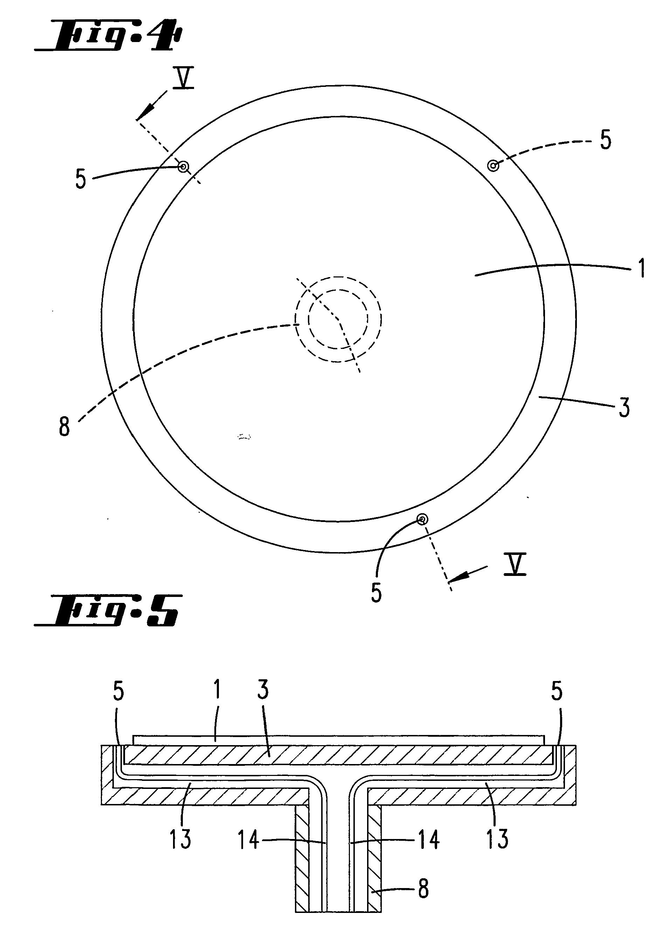

Bei dem in den Figuren 2 und 3 dargestellten Ausführungsbeispiel sind die Sensoren 4 Temperatursensoren in Form von jeweils Thermoelementen 4, 4'. Die elektrischen Zuleitungen 15 der Thermoelemente 4, 4' laufen durch Kanäle 13 des Substrathalters 3 und durch die hohle Antriebswelle 8 bis zum Sender 6. Dort werden die an den elektrischen Leitungen abfallenden Spannungen gemessen und in übertragbare Temperaturwerte umgewandelt, die vom Sender 6 an den Empfänger 7 gesandt werden.

Beim Ausführungsbeispiel der Figuren 2 und 3 sind zwei Arten von Thermoelementen 4, 4' vorgesehen. Die mit der Bezugsziffer 4 bezeichneten Thermoelemente liegen in einem Kanal 13 in Radialrichtung hintereinander in unterschiedlichen Radialpositionen etwa in der Querschnittsmitte des Substrathalters 3. Die mit 4' bezeichneten Sensoren liegen umfangsverteilt, beispielsweise jeweils um 120° versetzt, in einem unterschiedlichen Radialabstand zum Zentrum des Substrathalters 3 unmittelbar unterhalb des Substrates 1. Mit diesen Thermoelementen 4' kann somit die Temperatur der Substratrückseite gemessen werden.

Bei dem in den Figuren 4 und 5 dargestellten Ausführungsbeispiel handelt es sich bei den Sensoren um Drucksensoren 5. Diese Drucksensoren 5 werden von den Enden von Kapillaren ausgebildet. Diese Kapillarren werden von dünnen Edelstahlröhrchen (Achtel-Zoll-Rohre) ausgebildet. Diese Rohre 14 verlaufen ebenfalls durch Kanäle 13 des Substrathalters und durch die Höhlung der Antriebswelle 8 zu einem Druckaufnehmer, der dem Sender 6 zugeordnet ist. Dort wird Druck gemessen, der oberhalb der Mündung des Röhrchens in der Gasphase herrscht. Der Gasdruckwert wird in einen elektrischen Wert umgewandelt, vom Sender 6 gesendet und von der Antenne 7 empfangen.

## Patentansprüche

1. Vorrichtung zum Abscheiden dünner, insbesondere kristalliner Schichten auf mindestens einem, insbesondere kristallinen Substrat (1), mit einem in einem Reaktorgehäuse (2) drehbar angeordneten Substrathalter (3) und mit mindestens einem Sensor (4, 5) zum Messen eines Prozessparameters und einem Weiterleitungsmittel zum Weiterleiten des gemessenen Wertes Prozessparameters an eine Auswerteeinrichtung, **dadurch gekennzeichnet, dass** das Weiterleitungsmittel einen Sender (6) und einen Empfänger (7) zur drahtlosen Übermittlung des gemessenen Wertes aufweist, wobei der Sender (6) einer Antriebswelle (8) für den Substrathalter (3) zugeordnet und der Empfänger (7) außerhalb des Reaktorgehäuses angeordnet und eine die Antriebswelle (8) bzw. einen die Antriebswelle (8) aufnehmenden Wellenkanal (9) umgebende Ringantenne ist.

2. Vorrichtung nach Anspruch 1, **dadurch gekennzeichnet, dass** der mindestens eine Sensor (4) ein Thermoelement ist.

3. Vorrichtung nach einem der vorhergehenden Ansprüche, **dadurch gekennzeichnet, dass** der mindestens eine Sensor (5) ein Druckaufnehmer ist.

4. Vorrichtung nach einem der vorhergehenden Ansprüche, **gekennzeichnet durch** eine Vielzahl von Thermoelementen (4) bzw. Druckaufnehmern (5).

5. Vorrichtung nach einem der vorhergehenden Ansprüche, **dadurch gekennzeichnet, dass** die Sensoren (4, 5) an verschiedenen Radialpositionen im Substrathalter (3) angeordnet sind.

6. Vorrichtung nach einem der vorhergehenden Ansprüche, **dadurch gekennzeichnet, dass** die Sensoren (4, 5) an verschiedenen Umfangspositionen im Substrathalter (3) angeordnet sind.

7. Vorrichtung nach einem der vorhergehenden Ansprüche, **dadurch gekennzeichnet, dass** die Zuleitungen zu den Sensoren (4, 5) durch Kanäle (13) des Substrathalters (3) geführt sind.

8. Vorrichtung nach einem der vorhergehenden Ansprüche, **dadurch gekennzeichnet, dass** der das Druckmessgerät bzw. die Thermoelementauswerteschaltung örtlich dem Sender (6) zugeordnet ist.

9. Vorrichtung nach einem der vorhergehenden Ansprüche, **gekennzeichnet durch** vom Sender (6) bis zu den Messstellen führende Rohre (14).

## Claims

1. Device for depositing thin, in particular crystalline layers on at least one, in particular crystalline substrate (1), having a substrate holder (3), which is disposed rotatably in a reactor housing (2), and having at least one sensor (4, 5) for measuring a process parameter and a transfer means for transferring the measured value for the process parameter to an evaluation device,
**characterized in that** the transfer means includes a transmitter (6) and a receiver (7) for wireless communication of the measured value, the transmitter (6) being associated with a drive shaft (8) for the substrate holder (3), and the receiver (7) being disposed outside the reactor housing and being a ring antenna which surrounds the drive shaft (8) or a shaft passage (9) which accommodates the drive shaft (8).

2. Device according to claim 1, **characterized in that** the at least one sensor (4) is a thermocouple.

3. Device according to one or more of the preceding claims, **characterized in that** the at least one sensor (5) is a pressure pick-up.

4. Device according to one or more of the preceding claims, **characterized by** a multiplicity of thermocouples (4) or pressure pick-ups (5).

5. Device according to one or more of the preceding claims, **characterized in that** the sensors (4, 5) are disposed at various radial positions in the substrate holder (3).

6. Device according to one or more of the preceding claims, **characterized in that** the sensors (4, 5) are disposed at various circumferential positions in the substrate holder (3).

7. Device according to one or more of the preceding claims, **characterized in that** the leads to the sensors (4, 5) are routed through passages (13) in the substrate holder (3).

8. Device according to one or more of the preceding claims, **characterized in that** the pressure-measuring device or the thermocouple evaluation circuit is locally associated with the transmitter (6).

9. Device according to one or more of the preceding claims, **characterized by** tubes (14) leading from the transmitter (6) to the measurement locations.

## Revendications

1. Dispositif de dépôt de couches minces, notamment cristallines, sur au moins un substrat (1), notamment cristallin, ledit dispositif comportant un porte-substrat (3) placé de manière à pouvoir tourner dans un boîtier de réacteur (2) et au moins un capteur (4, 5) pour mesurer un paramètre de processus et un moyen de transmission pour transmettre la valeur mesurée du paramètre de processus à un dispositif d'exploitation, **caractérisé en ce que** le moyen de transmission comporte un émetteur (6) et un récepteur (7) permettant de transmettre sans fil la valeur mesurée, l'émetteur (6) étant associé à un arbre (8) d'entraînement du porte-substrat (3) et le récepteur (7) étant placé à l'extérieur du boîtier de réacteur et étant une antenne annulaire, qui entoure l'arbre d'entraînement (8), respectivement un canal d'arbre recevant l'arbre d'entraînement (8).

2. Dispositif selon la revendication 1, **caractérisé en ce qu'**au moins un des capteurs (4) est un élément thermique.

3. Dispositif selon l'une des revendications précédentes, **caractérisé en ce qu'**au moins un des capteurs (5) est un capteur de pression.

4. Dispositif selon l'une des revendications précédentes, **caractérisé par** une pluralité d'éléments thermiques (4) respectivement de capteurs de pression (5).

5. Dispositif selon l'une des revendications précédentes, **caractérisé en ce que** les capteurs (4, 5) sont disposés en des positions radiales différentes dans le porte-substrat (3).

6. Dispositif selon l'une des revendications précédentes, **caractérisé en ce que** les capteurs (4, 5) sont disposés en des positions périphériques différentes dans le porte-substrat (3).

7. Dispositif selon l'une des revendications précédentes, **caractérisé en ce que** les câbles menant aux capteurs (4, 5) sont guidés à travers des canaux (13) du porte-substrat (3).

8. Dispositif selon l'une des revendications précédentes, **caractérisé en ce que** l'appareil de mesure de pression, respectivement le circuit d'exploitation de l'élément thermique, est associé localement au capteur (6).

9. Dispositif selon l'une des revendications précédentes, **caractérisé par** des tubes (14) allant de l'émetteur (6) aux emplacements de mesure.
